# EUROPÄISCHE PATENTSCHRIFT

(11) **EP 0 914 678 B1**
(45) Veröffentlichungstag und Bekanntmachung des Hinweises auf die Patenterteilung: **10.11.2004**
(21) Anmeldenummer: 97935455.2
(22) Anmeldetag: 22.07.1997
(51) Int. Cl.: H01L 21/762

(54) **VERFAHREN ZUM AUFFÜLLEN VON GRÄBEN IN EINEM SUBSTRAT**
METHOD OF FILLING TRENCHES IN A SUBSTRATE
PROCEDE POUR REMPLIR DES FOSSES DANS UN SUBSTRAT

(30) Priorität: 23.07.1996 DE 19629766
(43) Veröffentlichungstag der Anmeldung: 12.05.1999
(73) Patentinhaber: Infineon Technologies AG, 81669 München (DE)
(72) Erfinder: ELBEL, Norbert, D-81825 München (DE); GABRIC, Zvonimir, D-85604 Zorneding (DE); NEUREITHER, Bernhard, D-81735 München (DE)
(74) Vertreter: Kindermann, Peter, Dipl.-Ing.
(86) Internationale Anmeldenummer: PCT/DE1997/001543
(87) Internationale Veröffentlichungsnummer: WO 1998/003992

(56) Entgegenhaltungen:
- EP-A- 0 545 263
- EP-A- 0 582 724
- US-A- 5 491 108
- US-A- 5 536 675
- PATENT ABSTRACTS OF JAPAN vol. 017, no. 657 (E-1470), 6.Dezember 1993 & JP 05 218031 A (SHARP CORP), 27.August 1993,

## Beschreibung

Die Erfindung betrifft ein Verfahren zum Auffüllen von Gräben in einem Substrat. Die Erfindung betrifft insbesondere ein Herstellungsverfahren von Shallow bzw. Deep-Trench-Isolationen auf einem Halbleitersubstrat.

Für die Isolation von aktiven Gebieten auf Halbleiterbausteinen wird in zunehmendem Maße die LOCOS-Isolation durch die sogenannte Shallow-Trench-Isolation (STI) bzw. durch eine Isolation mit tiefen Isolationsgräben ("Deep Trenches") ersetzt oder ergänzt. Insbesondere bei den neueren Speichergenerationen (16 M-DRAM und höher) und bei neueren Generationen von Logikbausteinen wird die STI wegen ihres im Vergleich zur LOCOS-Isolation höheren Schrinkpotentials vermehrt eingesetzt.

Jedoch ergeben sich insbesondere beim Planarisieren von beispielsweise oxidgefüllten Gräben eine Reihe von Schwierigkeiten. Durch das Auffüllen der Gräben werden an der Oberfläche des Halbleiterwafers große Topologieunterschiede erzeugt, die sich störend auf nachfolgende Prozeßschritte auswirken können. Dies hat zur Folge, daß diese Topologieunterschiede durch eine Planarisierung wieder entfernt werden müssen. Jedoch sind die Topologieunterschiede so groß, daß ein einfacher CMP-Prozeß (chemisch-mechanisches Polieren) nicht ausreicht. Eine Planarisierung durch Rückätzen erfordert ebenfalls eine komplexe und teure Prozeßführung.

Beispielsweise besteht der Prozeßablauf nach dem Stand der Technik für eine Shallow-Trench-Isolation darin, daß zunächst ein ca. 200 bis 500 nm tiefer Graben (Shallow-Trench) in das Siliziumsubstrat geätzt wird, danach der Graben mit TEOS-Oxid über einen LPCVD-Prozeß aufgefüllt wird und danach die so erzeugte Topologie planarisiert wird.

Der Planarisierungsschritt umfaßt im wesentlichen die folgenden Teilschritte:
1. Aufbringen und Strukturierung eines Fotoresists mit Hilfe einer Hilfs-Maske (PAIGE-Maske) . Die Maskengenerierung setzt dabei ein kompliziertes und aufwendiges Rechenverfahren voraus, da das Vorhanden- oder Nichtvorhandensein des Fotoresists vom sogenannten Patternfaktor abhängig ist.
2. Aufbringen einer weiteren Fotoresistschicht.
3. Nichtselektive Rückätzung von Fotoresist und Oxid.
4. Entfernen der restlichen Topologie durch Chemical Mechanical Polishing.

Dieses Verfahren ist sehr zeit- und kostenintensiv. Insbesondere für die Herstellung von neuen Logikbausteinen ist der Rechenaufwand für die Maskengenerierung für jedes einzelne Produkt neu durchzuführen, so daß hier ein enormer Zeit- und Kostenaufwand besteht.

Aus der US-amerikanischen Patentschrift US 5,536,675 ist ein Verfahren zur Bildung einer Isolationsstruktur für die Fertigung von Halbleiterschaltkreisen bekannt. Auf ein Halbleitersubstrat wird unter anderem eine Siliziumnitridschicht aufgebracht und strukturiert. Anschließend wird in dem Halbleitersubstrat ein Graben erzeugt. Der Graben wird mit einer Grabenoxidschicht bedeckt. Anschließend wird der Graben mit einem Füllmaterial aufgefüllt, das vorzugsweise konform abgeschieden wird.

Aus der Europäischen Patentanmeldung EP 0 582 724 A1 ist ein Verfahren zur lokal- und globalplanisierenden CVD-Abscheidung von SiO2-Schichten auf strukturierten Siliziumsubstraten bekannt. Die SiO2-Schicht dient als Isolierschicht zwischen den einzelnen Ebenen einer Mehrlagenverdrahtung bei höchstintegrierten Halbleiterschaltungen. Es wird vorgeschlagen, auf eine Aluminium-Leiterbahn, die auf einer Phosphorsilikatglas-Ebene (PSG) oder einer Borphosphorsilikatglas-Ebene (BPSG) aufgebaut ist, eine Plasmaoxidschicht aus Siliziumdioxid aufzubringen. Bei einem anschließend durchgeführten ozonaktivierten CVD-Prozess bei Atmosphärendruck ist das Verhältnis der Abscheideraten auf der Plasmaoxidschicht und auf der PSG- bzw. BPSG-Ebene unterschiedlich. Die Aufwachsrate auf der Plasmaoxidschicht ist geringer als die Aufwachsrate auf der PSG- bzw. BPSG-Ebene, so dass Höhenunterschiede beim Aufwachsen ausgeglichen werden.

Ein ähnliches Verfahren ist aus der japanischen Offenlegungsschrift JP 05-218031 bekannt.

Aufgabe der vorliegenden Erfindung ist es daher, ein neues Verfahren zum Auffüllen von Gräben in einem Substrat bereitzustellen, das mit geringem Zeit- und Kostenaufwand wirtschaftlich arbeitet und das ein strukturiertes Substrat ermöglicht, das eine optimale Planarität besitzt.

Diese Aufgabe wird durch ein Verfahren gemäß Patentanspruch 1 oder ein Verfahren gemäß Patentanspruch 2 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zum Auffüllen von Gräben in einem Substrat breitgestellt, das die folgenden Schritten umfaßt:
a) auf das Substrat wird eine Referenzschicht aufgebracht;
b) die Referenzschicht wird strukturiert;
c) in dem Substrat wird ein Graben erzeugt; und
d) auf die so erzeugte Struktur wird das zum Auffüllen des Grabens verwendete Material aufgebracht,
wobei die Referenzschicht so gewählt ist, daß die Wachstumrate des zum Auffüllen des Grabens verwendeten Materials auf der Referenzschicht mindestens um den Faktor 2 kleiner ist als die Wachstumrate des zum Auffüllen des Grabens verwendeten Materials auf der zu bedeckenden Oberfläche des Grabens. Diese zu bedeckende Oberfläche des Grabens wird üblicherweise aus Substratmaterial bestehen. Es könnten aber auch Zwischenschichten vorgesehen sein.

Der erfindungsgemäße Prozeßablauf umfaßt insgesamt deutlich weniger Prozeßschritte als die genannte STI-Technologievariante und bietet damit einen wesentlichen Kostenvorteil. Da das erfindungsgemäße Verfahren zu den darüber hinaus notwendigen Prozeßschritten kompatibel ist, kann es ohne Änderungen des Gesamtprozeßflusses in bestehende Technologien integriert werden. Darüber hinaus ist es sowohl für Shallow-Trench-Isolationen als auch für Deep-Trench-Isolationen anwendbar.

Bevorzugt ist als Substrat ein Siliziumsubstrat vorgesehen und bevorzugt wird zum Auffüllen des Grabens ein Isolationsmaterial, insbesondere Siliziumoxid, verwendet.

Weiterhin ist es bevorzugt, wenn als Referenzschicht eine Siliziumnitridschicht, eine Titannitridschicht oder eine Polysiliziumschicht, insbesondere eine dotierte Polysiliziumschicht, vorgesehen ist. Dabei wird das Siliziumoxid vorteilhafterweise in einem ozonaktivierten CVD-Verfahren, inbesondere SACVD-Verfahren, abgeschieden. Derartige ozonaktivierten CVD-Verfahren sind beispielsweise in der EP 0 582 724 A1 und in der EP 0 537 001 A1 eingehend beschrieben. Insbesondere ein SACVD-Abscheideprozeß zeichnet sich durch sehr gute Fülleigenschaften aus, was dazu führt, daß selbst Gräben mit einem großem Aspektverhältnis von 4:1 lunkerfrei gefüllt werden können.

Bevorzugt wird das zum Auffüllen des Grabens verwendete Material solange aufgebracht, daß sich eine im wesentlichen planare Oberfläche bildet. Da somit die Waferoberfläche bereits vor einem anschließenden CMP-Schritt im wesentlichen planar ist, tritt auch bei großen Grabengebieten während eines CMP-Schritts kein nennenswertes "Dishing" auf.

Die Referenzschicht kann direkt auf die Substratoberfläche aufgebracht werden. Alternativ kann jedoch auch zwischen dem Substrat und der Referenzschicht zumindest eine Zwischenschicht, insbesondere eine Oxidschicht, vorgesehen sein.

Nach dem Aufbringen des zum Auffüllen des Grabens verwendeten Materials wird eine thermische Oxidation (z. B. 900 - 1000°C für 10 - 30 min) durchgeführt. Diese Oxidation wirkt durch das bereits abschiedene Material, insbesondere durch das bereits abgeschiedene Siliziumoxid, und verringert im Substrat verbliebene Schäden, die während der Erzeugung des Grabens aufgetreten sein können. Desweiteren wird bei dieser Oxidation ein ausreichendes, sogenanntes "corner rounding" an den Oberkanten des Grabens erzielt.

Schäden im Substrat können auch durch eine Lineroxidation nach der Erzeugung des Grabens verringert werden. Allerdings muß das aufgewachsene Oxid anschließend naßchemisch wieder entfernt werden, da sonst die Selektivität des nachfolgenden Abscheideprozesses nicht gegeben ist. Dieses "Opferoxid" entfernt beispielsweise Ätzschäden und stationäre Ladungen an der Grabenkante, die die Isolationseigenschaften des Grabens beeinträchtigen würden.

Bevorzugt wird nach dem Aufbringen des zum Auffüllen des Grabens verwendeten Materials, der Teil des Materials, der über der Höhe der Referenzschicht angeordnet ist, wieder entfernt. Dazu wird vorteilhafterweise ein CMP-Verfahren verwendet.

Weiterhin ist bevorzugt, wenn sowohl flache Gräben als auch tiefe Gräben gleichzeitig aufgefüllt werden. Dies führt zu einer weiteren deutlichen Reduktion der Gesamtprozeßkomplexität und somit zu einer weiteren Reduzierung der Prozeßkosten.

Insbesondere ist bevorzugt, wenn das Verhältnis der Breite der tiefen Gräben zur Stufenhöhe (Ätztiefe + Dicke der Referenzschicht) der flachen Gräben etwa gleich 2*α /(α -1) ist, wobei α dem Verhältnis der Wachstumsrate des zum Auffüllen der Gräben verwendeten Materials auf der zu bedeckenden Oberfläche der Gräben zu der Wachstumsrate des zum Auffüllen der Gräben verwendeten Materials auf der Referenzschicht entspricht.

Weiterhin wird eine Isolationsstruktur bereitgestellt, die einen mit einem Isolationsmaterial aufgefüllten Graben in einem Halbleitersubstrat umfaßt. Die Isolationsstruktur ist dadurch gekennzeichnet, daß der Graben zumindest einen flachen Breich und zumindest einen tiefen Bereich aufweist.

Somit können die Vorteile eines flachen Grabens mit den Vorteilen eines tiefen Grabens verbunden werden.

Bevorzugt ist dabei das Verhältnis der Breite des tiefen Bereichs zur Tiefe des flachen Bereichs etwa gleich 2*α /(α - 1), wobei α dem Verhältnis der Wachstumsrate des zum Auffüllen des Grabens verwendeten Materials auf dem Substrat (2) zu der Wachstumsrate des zum Auffüllen des Grabens verwendeten Materials auf der Referenzschicht (5) entspricht. Die Erfindung wird nun anhand der Figuren näher erläutert. Gleiche Teile sind in den Figuren mit gleichen Bezugszeichen versehen. Es zeigen:
Fig. 1 bis 3 eine erste Ausführungsform des erfindungsgemäßen Verfahrens,
Fig. 4 bis 7 eine zweite Ausführungsform des erfindungsgemäßen Verfahrens, und
Fig. 8 eine erfindungsgemäße Isolationstruktur.

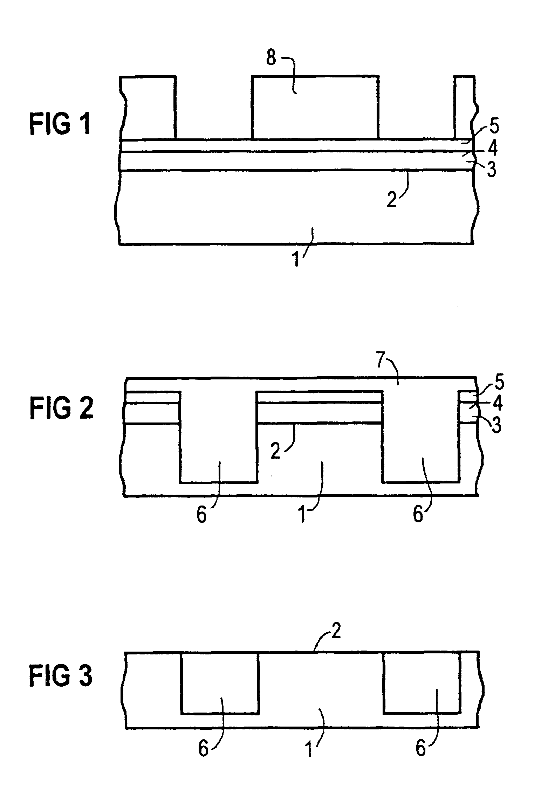

In Figur 1 ist ein Substrat gezeigt und mit 1 bezeichnet. Dieses Substrat 1 wird mit einer Oxidschicht 3 und einer Nitridschicht 4 bedeckt. Dieser Schichtaufbau wird auch als NIOX-Schicht bezeichnet. Die Nitridschicht (Si₃N₄) wird mit einem CVD-Verfahren hergestellt. Die Nitridschicht dient im wesentlichen als Diffusionsbarriere für die auf die NIOX-Schicht abgeschiedene Referenzschicht 5. Die Referenzschicht 5 besteht hier aus Titannitrid. Sie kann aber auch aus dotiertem Polysilizium bestehen. Die Titannitridschicht 5 wird auf die Nitridschicht über Sputtern abgeschieden. Danach wird ein Fotolack 8 aufgebracht, der zur Definition der Gräben 6 (Shallow-Trench) dient.

Anschließend werden in die Substratoberfläche 2 die Shallow-Trenches 6 geätzt.

In Figur 2 ist zu sehen, daß danach die geätzten Shallow-Trenches 6 mit Siliziumoxid 7 aufgefüllt werden, welches mit einem ozonaktivierten CVD-Verfahren abgeschieden wird.

Bei der ozonaktivierten Abscheidung von Siliziumoxidschichten können auf unterschiedlich beschaffenen Oberflächen unterschiedliche Aufwachsraten erzielt werden. Im vorliegenden Fall ist die Aufwachsrate von Siliziumoxid auf der Titannitridschicht 5 um einen Faktor 10-15 kleiner als die Aufwachsrate von Siliziumoxid auf dem Silizium der geätzten Shallow-Trenches.

Als Ausgangssubstanz für die CVD-Abscheidung sind neben TEOS insbesondere OMTC (Octa-Metyl-Zyklo-Tetra-Siloxan) bzw. HMDS (Hexa-Metyl-Disiloxan) geeignet.

Wie aus Figur 3 schließlich zu sehen ist, wird die auf der Substratoberfläche 2 abgeschiedene NIOX-Schicht 3, 4, die abgeschiedene Titannitridschicht 5 sowie das über das ozonaktivierte CVD-Verfahren abgeschiedene Siliziumoxid 7 entfernt, vorzugsweise durch Rückätzung. Danach kann die rückgeätzte Substratoberfläche 2 mittels eines CMP-Verfahrens (Chemical Mechanical Polishing) weiter planarisiert werden.

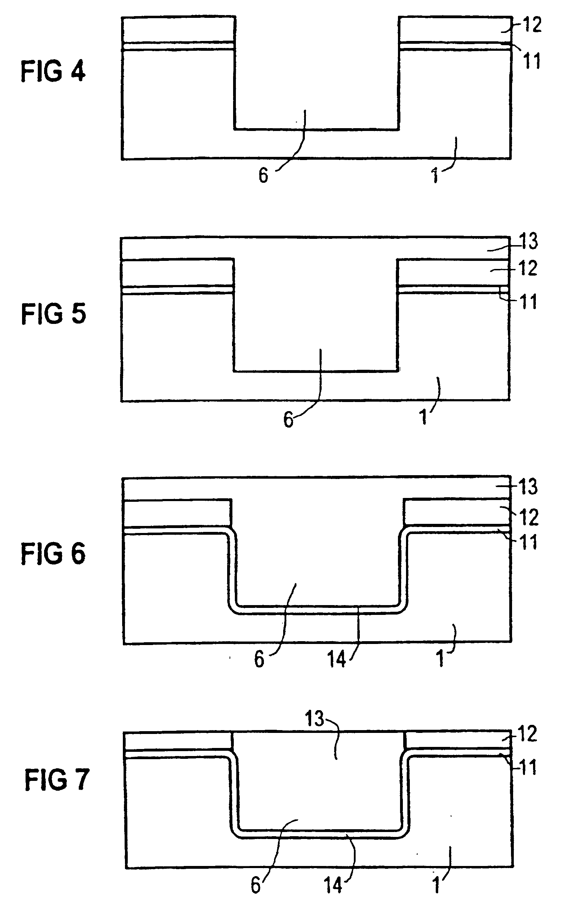

Die Figuren 4 bis 7 zeigen eine weitere Ausführungsform des erfindungsgemäßen Verfahrens. In Figur 4 ist ein Substrat gezeigt und mit 1 bezeichnet. Dieses Substrat 1 wird mit einer Oxidschicht 11 und einer Nitridschicht 12 bedeckt. Die Nitridschicht (Si₃N₄) wird mit einem CVD-Verfahren hergestellt. Bei dieser Ausführungsform bildet die Nitridschicht 12 die Referenzschicht.

Mittels einer Phototechnik wird die Nitridschicht 12 und die Oxidschicht 11 strukturiert. Anschließend wird durch anisotropes Ätzverfahren der Graben 6 in das Substrat 1 geätzt. Die sich daraus ergebende Struktur ist in Fig. 4 gezeigt.

Anschließend wird durch einen ozonaktivierten Abscheideprozeß auf der Nitridschicht (Si₃N₄) 12 eine Siliziumoxidschicht 13 erzeugt und gleichzeitig der Graben 6 mit Siliziumoxid aufgefüllt. Der Abscheideprozeß wird solange durchgeführt, bis durch das schnellere Wachstum der Siliziumoxidschicht in dem Graben 6 eine nahezu planare Oberfläche mit der Siliziumoxidschicht 13 über der Nitridschicht 12 erreicht wird. Die sich daraus ergebende Struktur ist in Fig. 5 gezeigt.

Es folgt eine thermische Oxidation. Die thermische Oxidation wirkt durch das bereits abgeschiedene Siliziumoxid (SiO₂) und erzeugt eine thermische Oxidschicht 14 an der Substratoberfläche innerhalb des Grabens 6. Die thermische Oxidation verringert im Substrat 1 verbliebene Schäden, die während der Ätzung des Grabens 6 aufgetreten können. Desweiteren wird mit dieser Oxidation ein ausreichendes, sogenanntes "corner rounding" an den Oberkanten des Grabens 6 erzielt. Die sich daraus ergebende Struktur ist in Fig. 6 gezeigt.

Anschließend wird das über der Höhe der Nitridschicht 12 angeordnete Siliziumoxid durch einen CMP-Schritt oder naßchemisch entfernt, so daß eine Struktur mit planen Oberfläche entsteht (Fig. 7).

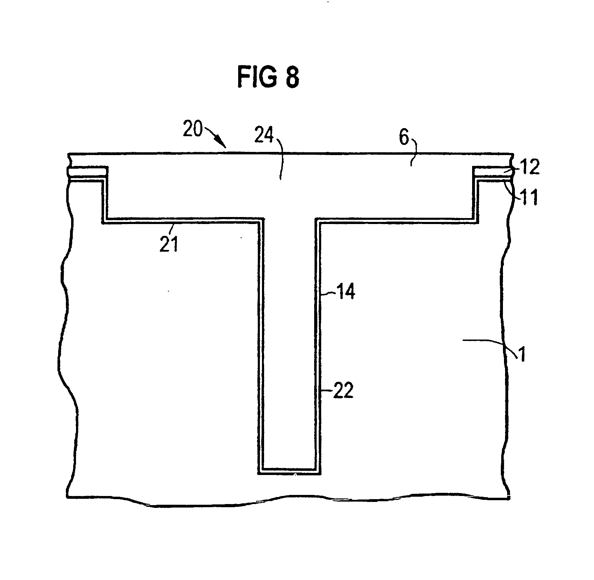

Figur 8 zeigt eine erfindungsgemäße Isolationstruktur 20. Die Isolationsstruktur (20) umfaßt einen mit Siliziumoxid 24 aufgefüllten Graben (6) in einem Halbleitersubstrat (1). Weiterhin weist die Isolationstruktur 20 einen flachen Breich 21 auf, der von der Oberfläche einer Siliziumnitridschicht 12 eine Stufenhöhe T besitzt. Darüber hinaus besitzt die Isolationstruktur 20 einen tiefen Bereich 22. Dieser Bereich 22 der Isolationstruktur 20 besitzt die Breite B. Dabei ist das Verhältnis der Breite B des tiefen Bereichs zur Stufenhöhe T des flachen Bereichs etwa gleich 2*α /(α -1),
wobei α dem Verhältnis der Wachstumsrate des zum Auffüllen des Grabens verwendeten Materials auf dem Substrat 2 zu der Wachstumsrate des zum Auffüllen des Grabens verwendeten Materials auf der Nitridschicht 12 entspricht.

Dadurch ist gewährleistet, daß beim Auffüllen der erfindungsgemäßen Isolationsstruktur eine nahezu planare Oberfläche des Siliziumoxids 24 entsteht.

## Patentansprüche

1. Verfahren zum Auffüllen zumindest eines Grabens in einem Substrat mit den Schritten:
a) auf das Substrat (1) wird eine Referenzschicht (5; 12) aufgebracht;
b) die Referenzschicht (5; 12) wird strukturiert;
c) in dem Substrat (1) wird ein Graben (6) erzeugt; und
d) auf die so erzeugte Struktur wird das zum Auffüllen des Grabens verwendete Material aufgebracht, wobei
die Referenzschicht (5; 12) und das Verfahren zum Aufbringen des zum Auffüllen des Grabens verwendeten Materials so gewählt sind, daß die Wachstumsrate des zum Auffüllen des Grabens (6) verwendeten Materials auf der Referenzschicht (5; 12) mindestens um den Faktor 2 kleiner ist als die Wachstumsrate des zum Auffüllen des Grabens (6) verwendeten Materials auf der zu bedeckenden Oberfläche des Grabens (6) und
nach dem Aufbringen des zum Auffüllen des Grabens (6) verwendeten Materials eine thermische Oxidation durchgeführt wird.

2. Verfahren zum Auffüllen zumindest eines Grabens in einem Substrat mit den Schritten:
a) auf das Substrat (1) wird eine Referenzschicht (5; 12) aufgebracht;
b) die Referenzschicht (5; 12) wird strukturiert;
c) in dem Substrat (1) wird ein Graben (6) erzeugt; und
d) auf die so erzeugte Struktur wird das zum Auffüllen des Grabens verwendete Material aufgebracht, wobei
die Referenzschicht (5; 12) und das Verfahren zum Aufbringen des zum Auffüllen des Grabens verwendeten Materials so gewählt sind, daß die Wachstumsrate des zum Auffüllen des Grabens (6) verwendeten Materials auf der Referenzschicht (5; 12) mindestens um den Faktor 2 kleiner ist als die Wachstumsrate des zum Auffüllen des Grabens (6) verwendeten Materials auf der zu bedeckenden Oberfläche des Grabens (6),
als Substrat (1) ein Siliziumsubstrat vorgesehen ist und zum Auffüllen des Grabens (6) ein Isoliermaterial, insbesondere Siliziumoxid, verwendet wird,
und nach der Erzeugung des Grabens (6) und vor dem Aufbringen des zum Auffüllen des Grabens verwendeten Materials eine Lineroxidation durchgeführt und das aufgewachsene Oxid wieder entfernt wird.

3. Verfahren nach Anspruch 2, **dadurch gekennzeichnet, daß** als Referenzschicht (5; 12) eine Siliziumnitridschicht, eine Titannitridschicht oder eine Polysiliziumschicht vorgesehen ist.

4. Verfahren nach Anspruch 2 oder 3, **dadurch gekennzeichnet, daß** das Siliziumoxid in einem ozonaktivierten CVD-Verfahren abgeschieden wird.

5. Verfahren nach einem der vorherstehenden Ansprüche, **dadurch gekennzeichnet, daß** das zum Auffüllen des Grabens (6) verwendete Material solange aufgebracht wird, daß sich eine im wesentlichen planare Oberfläche bildet.

6. Verfahren nach einem der vorherstehenden Ansprüche, **dadurch gekennzeichnet, daß** zwischen dem Substrat (2) und der Referenzschicht (5; 12) zumindest eine Zwischenschicht (3, 4), insbesondere eine oxidschicht vorgesehen ist.

7. Verfahren nach einem der vorherstehenden Ansprüche, **dadurch gekennzeichnet, daß** nach dem Aufbringen des zum Auffüllen des Grabens verwendeten Materials, der Teil des Materials, der über der Höhe der Referenzschicht (5; 12) angeordnet ist, wieder entfernt wird.

8. Verfahren nach Anspruch 7, **dadurch gekennzeichnet, daß** der Teil des Materials, der über der Höhe der Referenzschicht (5; 12) angeordnet ist, durch ein CMP-Verfahren wieder entfernt wird.

9. Verfahren nach einem der vorherstehenden Ansprüche, **dadurch gekennzeichnet,daß** sowohl flache Gräben als auch tiefe Gräben gleichzeitig aufgefüllt werden.

10. Verfahren nach Anspruch 9, **dadurch gekennzeichnet, daß** das Verhältnis der Breite der tiefen Gräben zur Stufenhöhe der flachen Gräben etwa gleich 2*α /(α - 1) ist, wobei α dem Verhältnis der Wachstumsrate des zum Auffüllen der Gräben verwendeten Materials auf der zu bedeckenden Oberfläche der Gräben zu der Wachstumsrate des zum Auffüllen der Gräben verwendeten Materials auf der Referenzschicht entspricht.

11. Verfahren nach Anspruch 1, **dadurch gekennzeichnet, daß** nach der Erzeugung des Grabens (6) und vor dem Aufbringen des zum Auffülle des Grabens verwendeten Materials eine Lineroxidation durchgeführt und das aufgewachsene Oxid wieder entfernt wird.

## Claims

1. Process for filling at least one trench in a substrate, having the following steps:
a) a reference layer (5;12) is applied to the substrate (1);
b) the reference layer (5;12) is patterned;
c) a trench (6) is produced in the substrate (1); and
d) the material used for filling the trench is applied to the structure thus produced,
in which case the reference layer (5;12) and the process for applying the material used for filling the trench are selected such that the growth rate of the material used for filling the trench (6) on the reference layer (5;12) is at least a factor of 2 less than the growth rate of the material used for filling the trench (6) on the surface of the trench (6) which is to be covered and after the application of the material used for filling the trench (6), thermal oxidation is carried out.

2. Process for filling at least one trench in a substrate, having the following steps:
a) a reference layer (5;12) is applied to the substrate (1);
b) the reference layer (5;12) is patterned;
c) a trench (6) is produced in the substrate (1); and
d) the material used for filling the trench is applied to the structure thus produced,
in which case the reference layer (5;12) and the process for applying the material used for filling the trench are selected such that the growth rate of the material used for filling the trench (6) on the reference layer (5;12) is at least a factor of 2 less than the growth rate of the material used for filling the trench (6) on the surface of the trench (6) which is to be covered, a silicon substrate is provided as the substrate (1) and an insulation material, in particular silicon oxide, is used for filling the trench (6), after the production of the trench (6), and before the application of the material used for filling the trench, liner oxidation is carried out and the oxide which has grown is removed again.

3. Process according to Claim 2,
**characterized in that** a silicon nitride layer, a titanium nitride layer or a polysilicon layer is provided as the reference layer (5;12).

4. Process according to Claim 2 or 3,
**characterized in that** the silicon oxide is deposited in an ozone-activated CVD process.

5. Process according to one of the preceding claims,
**characterized in that** the material used for filling the trench (6) is applied until an essentially planar surface is formed.

6. Process according to one of the preceding claims,
**characterized in that** at least one intermediate layer (3,4), in particular an oxide layer, is provided between the substrate (2) and the reference layer (5;12).

7. Process according to one of the preceding claims,
**characterized in that** after the application of the material used for filling the trench, that part of the material which is arranged above the level of the reference layer (5;12) is removed again.

8. Process according to claim 7,
**characterized in that** that part of the material which is arranged above the level of the reference layer (5;12) is removed again by a CMP process.

9. Process according to one of the preceding claims,
**characterized in that** both shallow trenches and deep trenches are filled simultaneously.

10. Process according to Claim 9,
**characterized in that** the ratio of the width of the deep trenches to the step height of the shallow trenches is approximately equal to 2*α/(α-1), where α corresponds to the ratio of the growth rate of the material used for filling the trenches on the surface of the trenches which is to be covered to the growth rate of the material used for filling the trenches on the reference layer.

11. Process according to Claim 1, **characterized in that** after the production of the trench (6) and before the application of the material used for filling the trench, liner oxidation is carried out and the oxide which has grown in removed again.

## Revendications

1. Procédé de remplissage d'au moins un sillon d'un substrat comprenant les stades dans lesquels :
a) on dépose sur le substrat (1) une couche (5,12) de référence ;
b) on structure la couche (5,12) de référence ;
c) on produit un sillon (6) dans le substrat (1 ) ; et
d) on dépose sur la structure ainsi produite la matière utilisée pour remplir le sillon, dans lequel
on choisit la couche (5,12) de référence et le procédé de dépôt de la matière utilisée pour remplir le sillon de façon à ce que la vitesse de croissance de la matière utilisée pour remplir le sillon (6) sur la couche (5,12) de référence soit plus petite au moins du facteur 2 que la vitesse de croissance de la matière utilisée pour remplir le sillon (6) sur la surface à recouvrir du sillon (6), et,
après le dépôt de la matière utilisée pour remplir le sillon (6), on effectue une oxydation thermique.

2. Procédé de remplissage d'au moins un sillon d'un substrat comprenant les stades dans lesquels :
a) on dépose sur le substrat (1) une couche (5,12) de référence ;
b) on structure la couche (5,12) de référence ;
c) on produit un sillon (6) dans le substrat (1) ; et
d) on dépose sur la structure ainsi produite la matière utilisée pour remplir le sillon dans lequel
on choisit la couche (5,12) de référence et le procédé de dépôt de la matière utilisée pour remplir le sillon de façon à ce que la vitesse de croissance de la matière utilisée pour remplir le sillon (6) sur la couche (5,12) de référence soit plus petite au moins du facteur 2 que la vitesse de croissance de la matière utilisée pour remplir le sillon (6) sur la surface à recouvrir du sillon (6),
on prévoit comme substrat (1) un substrat en silicium et on utilise pour remplir le sillon (6) une matière isolante, notamment de l'oxyde de silicium,
et, après la production du sillon (6) et avant le dépôt de la matière utilisée pour remplir le sillon, on effectue une oxydation liner.

3. Procédé suivant la revendication 2, **caractérisé en ce que** l'on prévoit comme couche (5, 12) de référence une couche de nitrure de silicium, une couche de nitrure de titane ou une couche de polysilicium.

4. Procédé suivant la revendication 2 ou 3, **caractérisé en ce que** l'on dépose l'oxyde de silicium dans un procédé CVD activé à l'ozone.

5. Procédé suivant l'une des revendications précédentes, **caractérisé en ce que** l'on dépose de la matière utilisée pour remplir le sillon (6) jusqu'à former une surface sensiblement plane.

6. Procédé suivant l'une des revendications précédentes, **caractérisé en ce que** l'on prévoit entre la substrat (2) et la couche (5, 12) de référence au moins une couche (3, 4) intermédiaire, notamment une couche d'oxyde.

7. Procédé suivant l'une des revendications précédentes, **caractérisé en ce qu'**après le dépôt de la matière utilisée pour remplir le sillon, on élimine à nouveau la partie de la matière qui est disposée au-dessus du niveau de la couche (5, 12) de référence.

8. Procédé suivant la revendication 7, **caractérisé en ce que** l'on élimine à nouveau la partie de la matière qui est disposée au-dessus du niveau de la couche (5,12) de référence par une procédé CMP.

9. Procédé suivant l'une des revendications précédentes, **caractérisé en ce que** l'on remplit en même temps tant des sillons peu profonds que des sillons profonds.

10. Procédé suivant la revendication 9, **caractérisé en ce que** le rapport de la largeur des sillons profonds à la hauteur de gradin des sillons peu profonds est à peu près égal à 2*α / (α - 1), α étant le rapport de la vitesse de croissance de la matière utilisée pour remplir les sillons sur la surface à recouvrir des sillons à la vitesse de croissance de la matière utilisée pour remplir les sillons sur la couche de référence.

11. Procédé suivant la revendication 1, **caractérisé en ce qu'**après la production du sillon (6) et avant le dépôt de la matière utilisée pour remplir le sillon, on effectue une oxydation liner et on élimine à nouveau l'oxyde qui s'est formé par croissance.
